# EUROPEAN PATENT SPECIFICATION

(11) **EP 1 969 613 B1**
(45) Date of publication and mention of the grant of the patent: **22.08.2012**
(21) Application number: 06830754.5
(22) Date of filing: 20.12.2006
(51) Int. Cl.: H01J 37/34, C23C 14/35

(54) **METHOD OF MANUFACTURING AT LEAST ONE SPUTTER-COATED SUBSTRATE AND SPUTTER SOURCE**
VERFAHREN ZUM HERSTELLEN MINDESTENS EINES SPUTTER-BESCHICHTETEN SUBSTRATS UND SPUTTER-QUELLE
PROCÉDÉ DE FABRICATION D'AU MOINS UN SUBSTRAT REVÊTU PAR PULVÉRISATION ET SOURCE DE PULVÉRISATION

(30) Priority: 22.12.2005 US 753144 P
(43) Date of publication of application: 17.09.2008
(73) Proprietor: Oerlikon Solar AG, Trübbach, 9477 Trübbach (CH)
(72) Inventor: ATAMNY, Fachri, CH-9475 Sevelen (CH); KADLEC, Stanislav, 150 00 Praha 5 (CZ); KRASSNITZER, Siegfried, A-6800 Feldkirch (AT); HAAG, Walter, CH-9472 Grabs SG (CH); GRUENENFELDER, Pius, CH-7323 Wangs SG (CH)
(74) Representative: Troesch Scheidegger Werner AG
(86) International application number: PCT/EP2006/069995
(87) International publication number: WO 2007/071719

(56) References cited:
- GB-A- 2 393 321
- US-A1- 5 345 207
- US-A1- 5 399 253
- US-A1- 5 685 959
- US-B1- 6 351 075

## Description

The present invention is generically directed to a method of manufacturing at least one sputter-coated substrate which comprises magnetic field enhanced sputter coating of the at least one substrate from a target arrangement which comprises at least one sputter target which has a sputtering surface.

The invention is further directed to a sputtering source which comprises at least one target which has a sputtering surface and magnetic field generating members so as to enhance sputtering.

In the art of coating substrates by means of a vacuum deposition process sputtering is known since long. Thereby, an electric field is applied between an anode and a target cathode, within a vacuum chamber, and a working gas, normally a noble gas as e.g. Argon, is inlet into the vacuum chamber. Simplified, the working gas is ionized by collision to form positive noble gas ions, which are accelerated by the addressed electric field towards the sputtering surface of the target, wherefrom target material is sputtered off into the vacuum atmosphere and deposited on one or more than one substrates which are to be coated. Replacing or adding to the working gas a reactive gas results in such reactive gas being activated in the plasma adjacent to the sputtering surface, and in substrate coating with reaction products of reactive gas and sputtered off target material.

The electrons which are freed by the gas ionizing process substantially contribute to the ongoing ionization.

Such sputtering process may be enhanced by applying a magnetic field adjacent the sputtering surface of the target with magnetic field components which are perpendicular to the electric field applied to the target cathode. The generic effect of applying such magnetic field is an additional acceleration especially of the lightweight electrons leading to an increased ionization rate of the gas molecules and thus to an increased plasma density in the area of the applied magnetic field.

The effect of magnetic field enhancing sputtering is further improved by shaping the addressed magnetic field, so as to result in a pattern of magnetic field lines which arc upon the sputtering surface considered in planes perpendicular to the sputtering surface and further form, considered in direction perpendicular to the addressed planes, a closed loop along the sputtering surface, often addressed in the respective art as a closed loop tunnel of magnetic field lines. This technique is generically known as magnetron sputtering. The effect of the closed loop tunnel of lines of magnetic field is that, due to mutual effect of such magnetic field and of the electric field, electrons are accelerated along and within the tunnel loop, leading there to a significantly increased plasma density. This results, in the loop area, in a significantly increased rate of sputtering. Due to the effect of the tunnel loop of magnetic field lines cooperating with the electric field, the tunnel area is often called "electron trap". The effect on the target is an increased sputter rate in the area covered by the tunnel loop. The resulting loop shaped sputtering profile in the sputtering surface is often called "race track".

The generic problem which is addressed by the present invention is that whenever magnetic field-enhanced sputtering is performed, some areas of the sputtering surface of the target are more sputter eroded than others. Clearly, whenever a target is locally more sputter eroded than other areas, target life is dictated by the time at which the target is consumed at the areas of increased erosion. Therefore, uneven sputter erosion distribution along the target significantly dictates the efficiency with respect to the percentage of material which may be exploited for sputter coating from a given target. Further, a locally pronounced sputter erosion deteriorates homogeneity of the deposition rate of sputtered off material along a substrate.

A multitude of different approaches are known to ameliorate the addressed effect of magnetic field enhanced sputtering which comprises on one hand tailoring of a stationary tunnel-shaped magnetic field so as to result in increased components of magnetic field lines which are parallel to the sputtering surface and thus perpendicular to the electric field and adjacent that surface.

Other approaches are dynamic and move the magnetic field along the sputtering surface, thereby equalizing sputter erosion of the target over the time.

From the JP 5148642, fig. 11, it is e.g. known to provide a first stationary and elongated arrangement of magnetic poles along a target. Distant from and along such stationary and elongated arrangement of magnetic poles there is provided, beneath the sputtering surface, a dynamic and elongated arrangement of magnetic poles realized by an elongated drum revolving about an axis parallel to and distant from the addressed stationary and elongated arrangement. An arcing magnetic field is generated between the magnetic poles at the drum and the magnetic poles of the stationary arrangement. Due to the fact that upon the addressed drum the magnetic poles are arranged in a helical pattern, seen from the sputtering surface of a target, these poles are moved linearly along the stationary and elongated arrangement of magnetic poles. The magnetic field enhancing the sputtering process thus arcs upon the sputtering surface of the target from the stationary and elongated arrangement of magnetic poles to the dynamic arrangement of linearly moved magnetic poles or vice versa.

Such an approach has several disadvantages. One thereof is that the resulting magnetic field is substantially governed by the strength of magnets on the dynamic arrangement. A second one is that the resulting magnetic field is in fact only parallel to the sputtering surface along a very limited central area between the dynamic arrangement and the stationary elongated arrangement of magnetic poles.

Similarly, US 6351075B1 discloses a plasma processing apparatus, which generates time variable magnetic flux lines between stationary and rotary magnet systems.

It is an object of the present invention to provide a different approach.

This is achieved, according to the present invention, by a method of manufacturing at least one sputter-coated substrate according to claim 1 which method comprises magnetic field-enhanced sputter coating of the at least one substrate from a target arrangement which has at least one sputter target having a sputtering surface. Thereby, there is generated a time-varying magnetic field on the sputter surface which is done by a first stationary and elongated arrangement of magnetic poles and a second stationary and elongated arrangement of magnetic poles, whereby the first and the second stationary and elongated arrangements are disposed mutually spaced and one along the other. At least one of the addressed stationary and elongated arrangements is situated under the sputtering surface. The two arrangements of magnetic poles commonly generate a stationary magnetic field which has a pattern of magnetic field lines which are arcing above the sputtering surface as considered in respective planes perpendicular to the sputtering surface. The addressed pattern of magnetic field lines further is tunnel-like, namely considered in the direction perpendicular to the addressed planes. There is superimposed a modulating magnetic field to the stationary magnetic field just adjacent at least one of the first and of the second stationary and elongated arrangements of magnetic poles and along at least a predominant part of the length extent of the addressed one arrangement.

### Definitions

- When we speak of the sputtering surface of a target and use such surface as a geometric entity to other geometric entities thereto, we understand the sputtering surface as a geometric plane or possibly a bent geometric surface, disregarding any unsteadiness of the practical sputtering surface as introduced by target mounting arrangements or and especially sputter erosion profiles.
- Whenever we speak of "adjacent" to a stationary and elongated arrangement of magnetic poles we understand such "adjacent" to define a position which is substantially closer to the addressed arrangement than to the other or others stationary and elongated arrangement(s) of magnetic poles.

By the fact that a stationary magnetic field with the tunnel-shaped pattern of magnetic field lines is generated by means of elongated arrangements of magnetic poles which are stationary on one hand the overall strength of the magnetic field is governed by stationary magnetic poles and thus respective magnet arrangements. The stationary magnetic field acts as working point field. On the other hand the option is opened to exploit stationarily measures to optimize magnetic field lines parallel to the sputtering surface.

By additionally superimposing a dynamic modulating magnetic field to the working point field adjacent the at least one of the stationary and elongated arrangements an increasing extent of the effect of magnetic field line components parallel to the sputtering surface is achieved adjacent to the addressed one stationary arrangement. Thereby, the magnetic poles which govern the overall strength of the magnetic field of tunnel-shaped pattern need not be dynamically moved by a drive.

In one embodiment of the method according to the present invention the addressed modulating is performed time- and location-dependent along the at least one stationary and elongated arrangement, leading to a wavelike modulation along the one stationary arrangement.

In a further embodiment the addressed modulating comprises moving a dynamic arrangement of one or of alternate polarity magnetic poles adjacent to, perpendicularly and/or along the one stationary and elongated arrangement of magnetic poles, whereby one polarity poles of the moved arrangement are mutually spaced in direction of moving.

In a further embodiment the addressed modulating comprises moving an arrangement of ferromagnetic shunt members adjacent to, perpendicularly to and/or along the at least one stationary and elongated arrangement of magnetic poles, whereby the shunt members are mutually spaced in direction of moving. Magnetic poles of both polarities and ferromagnetic shunt members may be combined in one and the same arrangement which is moved.

In a further embodiment, which is especially suited to be applied for magnetic field-enhanced sputtering of the magnetron type, the method comprises providing a third stationary and elongated arrangement of magnetic poles, thereby the second stationary arrangement of magnetic poles being disposed in between the first and the third stationary and elongated arrangements of magnetic poles and beneath the sputtering surface. The addressed modulating is performed adjacent to and along the second stationary and elongated arrangement of magnetic poles, i.e. at that arrangement which is provided in between the other two stationary and elongated arrangements of magnetic poles.

In one embodiment, the modulating magnetic field is selected to be stronger than the stationary magnetic field whereupon it is superimposed.

In another embodiment the superimposed modulating magnetic field is selected to be weaker than the stationary magnetic field it is superimposed to.

It is to be noted that along the one stationary and elongated arrangement of magnetic poles, in some segments of extent the modulating field may be stronger, in other segments weaker than the stationary magnetic field it is superimposed to.

In a further embodiment of the method according to the present invention the addressed modulating includes providing a drum which is rotatable about an axis and located adjacent to the addressed one stationary and elongated arrangement. The drum has a pattern of at least one of ferromagnetic members and of magnetic poles.

By revolving the drum ferromagnetic members and/or magnetic poles are moved towards and from the magnetic poles of the one stationary and elongated arrangement, and thus perpendicularly to the length extent of the stationary arrangement.

In a further embodiment, at least two targets are provided disposed one beside the other, whereby the one stationary and elongated arrangement of magnetic poles, i.e. that one whereat modulating is performed, is disposed substantially between the at least two targets. Thereby, the addressed modulation affects stationary magnetic fields on both targets.

Still in a further embodiment the method according to the present invention comprises flattening the stationary magnetic field by means of a stationary and elongated arrangement of magnetic dipoles arranged along and between the first and second stationary and elongated arrangements of magnetic poles. The dipole axes are thereby substantially parallel and beneath the sputtering surface of the target.

Still in a further embodiment departing from an embodiment with first, second and third stationary and elongated arrangements of magnetic poles, the stationary magnetic field is flattened between the third and second stationary and elongated arrangements of magnetic poles by means of stationary and elongated arrangements of magnetic dipoles arranged along and between the first and second and between the third and the second stationary and elongated arrangements of magnetic poles. The dipole axes are thereby substantially parallel and beneath the sputtering surface.

The present invention is further directed on a sputtering source according to claim 13 which comprises
at least one sputter target having a sputter surface,
a first stationary and elongated arrangement of magnetic poles along said target,
a second stationary and elongated arrangement of magnetic poles disposed mutually spaced and along said first stationary and elongated arrangement of magnetic poles.

At least one of the first and of the second stationary and elongated arrangements of magnetic poles is disposed beneath the sputtering surface. The first and second stationary and elongated arrangements commonly generate a stationary magnetic field which has a pattern of magnetic field lines which arc upon the sputtering surface as considered in respective planes perpendicular to the addressed sputtering surface. The pattern is further tunnel-like, namely when considered in a direction perpendicular to the addressed planes.

The sputtering source further comprises a dynamic arrangement of at least one spaced apart ferromagnetic members and of magnetic poles which is drivingly movable adjacent to one of the first and of the second stationary and elongated arrangements of magnetic poles.

Thereby, a further dynamic arrangement of spaced apart ferromagnetic members and/or of magnetic poles may be provided drivingly movable adjacent and along the other of said first and second stationary and elongated arrangements of magnetic poles.

Looking back on the method of manufacturing according to the present invention, clearly superimposing a modulating magnetic field to the stationary magnetic field may additionally be performed adjacent the other of the first and of the second stationary and elongated arrangements of magnetic poles. Nevertheless, one modulating magnetic field considered affects the stationary magnetic field substantially along one of the addressed first and second stationary and elongated arrangements of magnetic poles.

In an embodiment of the sputtering source according to the present invention the addressed dynamic arrangement is drivingly movable adjacent the one of the first and second stationary and elongated arrangements of magnetic poles and perpendicularly and/or along the just addressed one arrangement. Thereby, modulation of the stationary magnetic field may be performed in a wavelike manner time- and location-dependent along the addressed one stationary and elongated arrangement of magnetic poles.

In one embodiment of the sputtering source according to the invention the source comprises a third stationary and elongated arrangement of magnetic poles, whereby the second stationary and elongated arrangement is disposed between the first and the third stationary and elongated arrangements and beneath the sputtering surface. The one stationary and elongated arrangement of magnetic poles to which the dynamic arrangement is adjacent to is the second stationary arrangement of magnetic poles.

In one embodiment of the source according to the present invention the stationary magnetic field is stronger than a magnetic field which is generated with at least a part of said magnetic poles of the dynamic arrangement considered at a common locus along and adjacent the one stationary and elongated arrangement of magnetic poles to which the dynamic arrangement is associated.

In a further embodiment of the source the stationary magnetic field is weaker than a magnetic field generated with at least a part of the magnetic poles of the dynamic arrangement considered at a common locus along and adjacent the one stationary and elongated arrangement of magnetic poles.

Thereby, the embodiments just addressed may be combined so that along one part of the stationary magnetic field the latter is stronger, along another part weaker than the respectively associated magnetic field which is generated with the dynamic arrangement.

In one embodiment of the source according to the invention the dynamic arrangement comprises a drum which is drivingly rotatable about an axis and which comprises a pattern of the addressed at least one of ferromagnetic members and of magnetic poles.

In a further embodiment the just addressed pattern is a helical pattern around the surface of the drum.

In a further embodiment the source according to the present invention comprises at least two targets disposed one beside the other and the one stationary and elongated arrangement of magnetic poles which is associated to the dynamic arrangement as addressed is disposed substantially between the at least two targets.

In a further embodiment of the source according to the present invention there is provided a stationary and elongated arrangement of magnetic dipoles along and between at least the first and second stationary and elongated arrangements of magnetic poles, the axes of the dipoles being substantially parallel to the sputtering surface and disposed adjacent to and beneath the sputtering surface.

Under a further aspect of the present invention there is proposed a method of manufacturing at least one sputter-coated substrate which comprises magnetic field-enhanced sputter-coating the at least one substrate from a target arrangement which comprises at least one sputter target having a sputter surface. Thereby, there is generated a time-varying magnetic field on the surface of the sputter target by a first stationary and elongated arrangement of magnetic poles and a second stationary and elongated arrangement of magnetic poles. The first and the second stationary and elongated arrangement are disposed mutually spaced and one along the other. At least one of the addressed arrangements is located beneath the sputtering surface. The first and second stationary and elongated arrangements commonly generate a stationary magnetic field which has a pattern of magnetic field lines arcing above the sputtering surface as considered in respective planes perpendicular to the sputtering surface. The magnetic field lines are further tunnel-like patterned considered in a direction perpendicular to the addressed planes. The addressed stationary magnetic field is controllably unbalanced, so as to result in the time-varying magnetic field.

Under a further aspect of the present invention there is proposed a method of modulating plasma density which comprises generating a magnetic field in a plasma exclusively by a drum with a helical pattern of magnetic poles rotated about the axis of the drum.

The invention shall now further be explained by means of examples and respective figures.

The figures show:
- Fig. 1: a schematic perspectivic view of a magnet arrangement as provided at a source according to the present invention and according to the method of this invention, for explaining the generic approach of the present invention;
- Fig. 2: still schematically, a stationary magnetic field and the modulation thereof as exploited by the present invention;
- Fig. 3: over the time axis, modulation of the stationary magnetic field as a working point defining field;
- Fig. 4: a part of a magnet arrangement with applied wavelike modulation of the stationary magnetic field and as exploited in one embodiment of the source and method according to the present invention;
- Fig. 5: schematically, a part of a magnet arrangement with a first embodiment of modulating the stationary magnetic field according to the present invention;
- Fig. 6: a representation in analogy to that of fig. 5 with a second embodiment of realizing the modulation of the stationary magnetic field as of the present invention;
- Fig. 7: in a representation in analogy to that of the fig. 5 and 6, a third embodiment of modulating the stationary magnetic field according to the present invention;
- Figs. 8: to 10 still in representations in analogy to those of the fig. 5 to 7, three further embodiments of modulating the stationary magnetic field according to the present invention;
- Fig. 11: in a perspectivic, schematic representation, an embodiment for realizing a flattened stationary magnetic field as exploited in embodiments of the present invention;
- Fig. 12: realizing modulation of a stationary magnetic field generated by an embodiment as of fig. 11 in a magnetron-type pattern according to embodiments of the invention;
- Fig. 13: the embodiment of fig. 12 without modulating, showing the resulting, flattened stationary magnetic field;
- Fig. 14a) to d): Departing from an embodiment according to fig. 12, the development of magnetic field and sputter erosion profile along the sputtering surface when modulating the stationary magnetic field as of fig. 13 according to the present invention;
- Fig. 15: at the embodiment shown in fig. 14, the resulting erosion profile along the sputtering surface of the target;
- Fig. 16: a drum with a helical pattern of magnetic poles with the resulting magnetic field as exploited in some embodiments of the present invention for modulating the stationary magnetic field;
- Fig. 17: the resulting areas of higher plasma density upon a sputtering target caused by a drum per se as shown in fig. 16;
- Fig. 18: an embodiment according to fig. 12 in top view using a drum as shown in fig. 16 with resulting moving electron traps when the stationary magnetic field is relatively low compared with the modulating magnetic field of the drum;
- Fig. 19: in a representation similar to that of fig. 18, the snakelike moving electron trap which results at the embodiment of fig. 18 if, in opposition thereto, the stationary magnetic field is relatively strong compared with the modulating magnetic field of the drum;
- Fig. 20: in a representation in analogy to that of fig. 14, two embodiments with multiple targets and multiple modulations per target according to the present invention;
- Fig. 21: a further embodiment of the present invention which makes use of ferromagnetic members for modulating the stationary magnetic field, realized in an embodiment according to fig. 13;
- Fig. 22: five examples of modulating drums as applied in some embodiments of the present invention with helical pattern of magnetic poles differently tailored along subsequent segments of the drums, considered along their length extent, and
- Fig. 23: schematically, the stationary magnetic field as applied according to the present invention and the modulation thereof by controlled unbalancing.

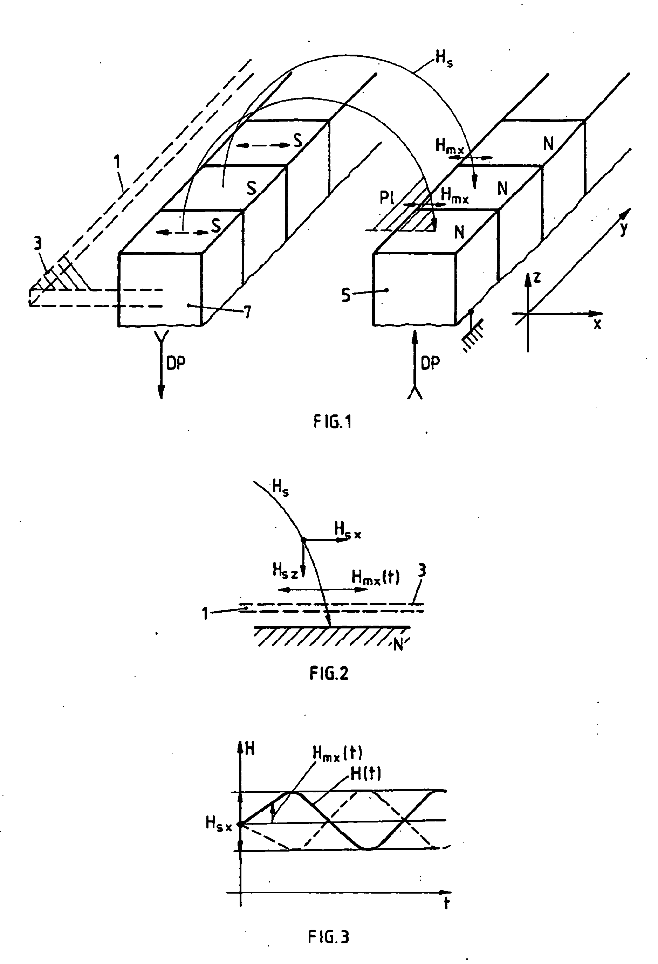

In fig. 1 there are shown schematically parts of a sputtering source according to the present invention for explaining the generic approach according to the invention. There is provided a target 1 shown in dashed lines having a sputtering surface 3. A first arrangement 5 of magnetic poles is extended in one direction y and presents magnetic poles of a dipole DP. The magnetic poles may be of specifically selected alternating polarity, but will normally at least along some extent of the arrangement 5 be of the same polarity, as indicated e.g. S. The arrangement 5 is mounted stationary with respect to the target 1.

There is provided a second arrangement 7 of magnetic poles of dipoles DP which is as well extended in direction y and which is spaced from the arrangement 5. The magnetic poles presented by the arrangement 7 may again be of different polarities, but, here too, are normally and at least along a part of the extent of the arrangement 7 equal, as indicated by N. At least one of the two stationary and elongated arrangements of magnetic poles 5, 7 is mounted beneath the sputtering surface 3 of target 1. By the two stationary and elongated arrangements 5 and 7 and in fact the associated dipoles DP there is generate a stationary magnetic field H_{S}. The magnetic field lines thereof are arcing between the two arrangements 5 and 7, in planes Pl perpendicular to the sputtering surface 3 and upon the sputtering surface 3. According to the representation of fig. 1 these planes Pl are perpendicular to the direction y. In combination, the magnetic field lines form a tunnel arcing above the sputtering surface 3 and considered in y direction, i.e. in direction perpendicular to the planes Pl.

In fig. 2 there is schematically shown the part of the stationary magnetic field H_{S} impinging on the magnetic poles of the polarity S as of the arrangement 5 of fig. 1. According to the invention and as shown in fig. 2 schematically and enlarged, the stationary magnetic field H_{S} has magnetic field components H_{Sx} parallel to the sputtering surface 3 as well as components H_{Sz} perpendicular to the sputtering surface 3. According to the invention there is applied adjacent to the stationary and elongated arrangement of magnetic poles a modulating magnetic field Hₘ which has a time-varying magnetic field component Hₘₓ(t). Due to the superposition of the stationary magnetic field component parallel to the sputtering surface, H_{Sx} and of the time varying component Hₘₓ of the modulating magnetic field Hₘ the resulting magnetic field component parallel to the sputtering surface 3 is time varying too.

In fig. 3 there is shown over the time axis t the component H_{Sx} of the stationary magnetic field H_{S} as a working point value of magnetic field and the modulating component Hₘₓ(t) of magnetic field resulting in superposition result magnetic field H(t).

Thus, the stationary magnetic field H_{S}, arcing from one arrangement 7 to the second one 5 and over the sputtering surface 3 of the target 1, may be said defining for the working point magnetic field on which the modulating time-variable magnetic field Hₘ is superimposed adjacent to and along the one stationary and elongated arrangement 5 of magnetic poles, according to fig. 1. As shown in fig. 1 in dashed lines the stationary magnetic field H_{S} may also be modulated by a further superimposed modulating magnetic field adjacent to and along the second stationary and elongated arrangement of magnetic poles, 7, e.g. and as shown in fig. 3 also in dashed lines in phase opposition.

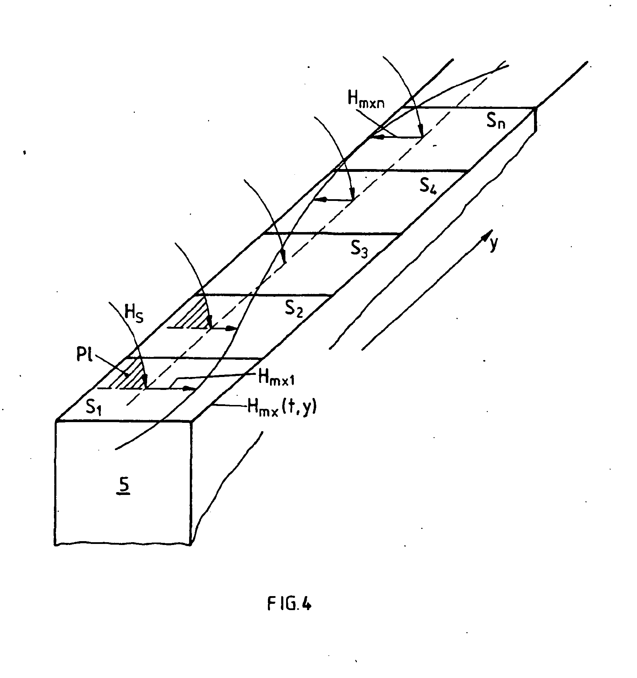

In fig. 4 there is shown in an enlarged representation the one stationary and elongated arrangement 5 of magnetic poles adjacent to which the stationary magnetic field H_{S} is modulated by the modulating magnetic field Hₘ. In this embodiment the modulation adjacent to magnetic poles S₁..Sₙ along direction y are correlated with respect to phasing so that there is realized a modulation pattern Hₘₓ (t,y) along the extent of arrangement 5 which propagates like a wave.

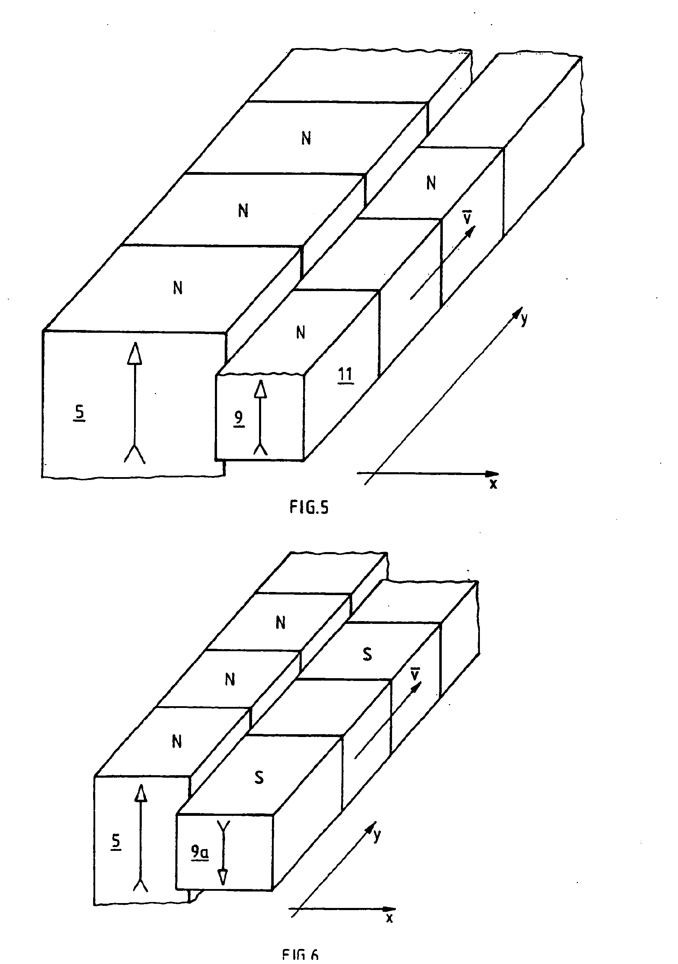

In fig. 5 there is shown, in an enlarged representation, the one stationary and elongated arrangement 5 of magnetic poles according to fig. 1, thereby the double arrows represent, as they also do in the other figures, the magnetic dipoles which result in the magnetic poles at the respective arrangements. The modulating magnetic field Mₘ according to the figures 1 to 3 is realized by moving linearly, according to the arrow v, an arrangement of magnetic poles adjacent to and along the one stationary arrangement. As further shown in fig. 5 the dynamic arrangement 9 in this embodiment provides for magnetic poles interacting with magnetic poles of the stationary arrangement 5 of equal polarity. If more than one magnetic pole is provided along arrangement 9 as shown in fig. 5, the equal magnetic poles along the extent of the dynamic arrangement 9 are mutually spaced. By drivingly moving the dynamic arrangement 9 adjacent to and along the stationary and elongated arrangement 5 the stationary magnetic field (not shown in fig. 5) is modulated at each of the magnetic poles of the stationary and elongated arrangement 5. Heuristically one may say that whenever two of the equal polarity magnetic poles of the arrangement 5 and 9 are aligned the magnetic field component H_{Sx} of the stationary magnetic field as of fig. 2 are increased adjacent to the magnetic poles of the stationary and elongated arrangement 5 and thus adjacent to the respective area of the sputtering surface.

Fig. 6 shows in a representation equal to that of fig. 5 the arrangement of the one stationary and elongated arrangement of magnetic poles 5 cooperating with a dynamic arrangement of magnetic poles 9a, whereby the magnetic poles of the dynamic arrangement 9a are of opposite polarity to the magnetic poles of the stationary and elongated arrangement 5. Again heuristically, whenever two magnetic poles respectively of the stationary and of the dynamic arrangements 5 and 9a are or come into alignment, this results in weakening the magnetic field component parallel to the sputtering surface, Hₘₓ as of fig. 2 adjacent to and above the sputtering surface.

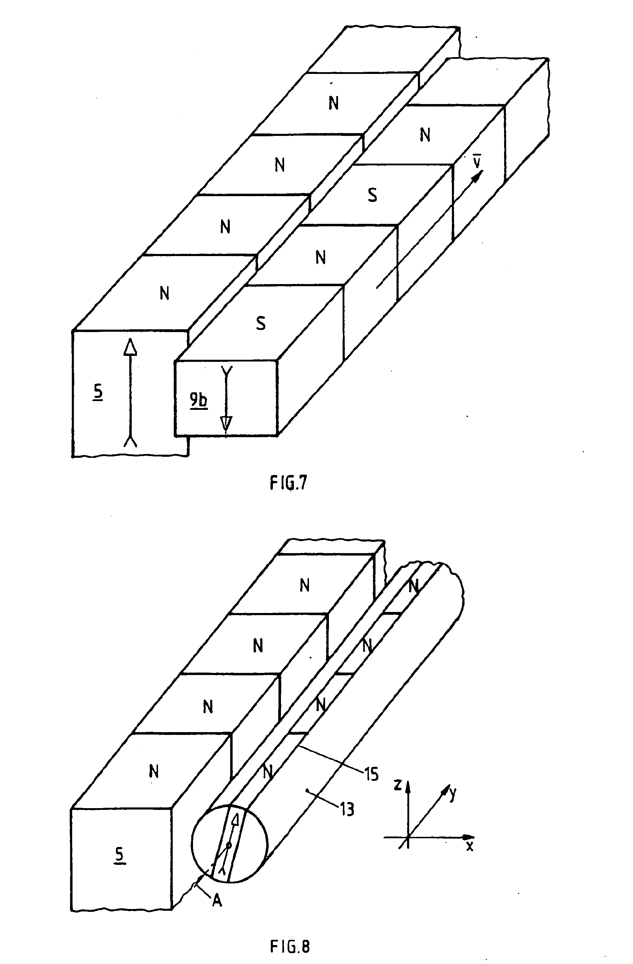

Fig. 7 shows a representation in analogy to those of the figs. 5 and 6 with the exception that here the dynamic arrangement of magnetic poles has at least a pair of subsequent magnetic poles of alternate polarity. By moving the dynamic and elongated arrangement 9b adjacent to and along the stationary and elongated arrangement 5 of magnetic poles the magnetic field components parallel to the sputtering surface are increased and reduced alternatively and in phase opposition at subsequent areas of sputtering surface adjacent to the magnetic poles of the stationary and elongated arrangement 5.

With an eye on the embodiment according to the figs. 5 and 6 some or all of the magnetic poles and the respective magnetic dipole members as shown at 11 of fig. 5 may be replaced by ferromagnetic members, resulting in shunting a part of the stationary magnetic field H_{S} and thereby unbalancing the stationary magnetic field there where such ferromagnetic shunting member is momentarily adjacent a respective magnetic pole of the stationary and elongated arrangement 5 in a modulating manner. Further, such ferromagnetic shunting members may be applied in between the magnetic poles as of the fig. 5, 6 or 7. By such ferromagnetic shunting members, the stationary magnetic field H_{S} is modulated.

Fig. 8 shows in a representation similar to that of the figs. 5 to 7 a further embodiment for realizing modulation of the stationary magnetic field H_{S} as of fig. 1. Adjacent to and along the one stationary and elongated arrangement of magnetic poles 5, there is provided a drum drivingly rotated about an axis A which is oriented parallel to the stationary and elongated arrangement 5. In drum 13 there are provided magnetic dipole members 15 respectively aligned with the magnetic poles along the stationary and elongated arrangement 5. In the embodiment of fig. 8 the dipoles of the members 15 are all aligned in direction and polarity. By rotating drum 13 the stationary magnetic field H_{S} impinging upon the sputtering surface adjacent to the magnetic poles of stationary arrangement 5 are all equally and simultaneously modulated by the alternatingly effective polarities of the dipole members 15 along the revolving drum 13 which are here in fact moved towards and from the arrangement 5, along the x axis.

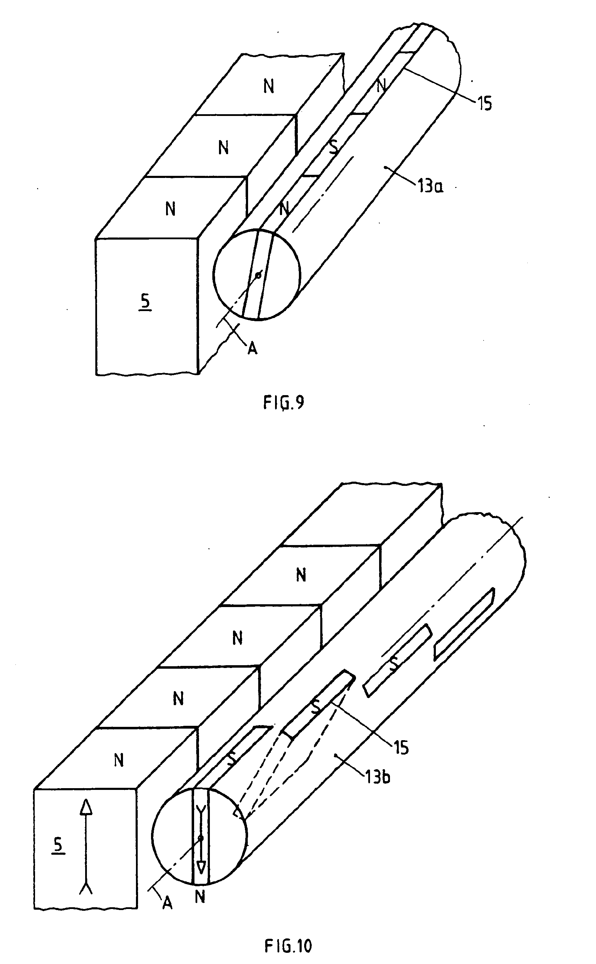

Fig. 9 shows an embodiment similar to that of fig. 8 in an equal representation. The difference between the embodiment of fig. 8 and that of fig. 9 is that the drum 13a in the embodiment of fig. 9 has dipole members 15 which are arranged along drum 13a with magnetic dipoles of alternating polarity. By this embodiment a modulation substantially equally to that as achieved by the embodiment of fig. 7 is realized. Nevertheless and from a constructional point of view realization by means of a drivingly rotatable drum as of the embodiment of fig. 9 is highly advantageous compared with realization by means of a linearly moved arrangement as of fig. 7.

With an eye on the embodiments according to the figs. 5 - 7 it has to be emphasized that the length extent of the respective dynamic arrangements 9, 9a and 9b respectively needs by no means be equal to such length extent of the stationary and elongated arrangements 5. Thus, with an eye on the embodiments of fig. 5 and 6 the dynamic and elongated arrangement may be reduced to comprise just one member defining for one magnetic polarity. In the embodiment of fig. 7 the addressed length may be reduced to comprise just a pair of opposite polarity pole pieces.

In fig. 10 there is shown a further embodiment similar to those as shown in the fig. 8 and 9. The difference of the embodiment according to fig. 10 to those of the fig. 8 and 9 is that the dipole members 15 are arranged along the drivingly rotatable drum 13b to form a screw-thread-like helical pattern of magnetic poles along the extent of drum 13b. Thereby, modulation of the stationary magnetic field H_{S} is performed over time with defined phasing as considered from one dipole member 15 to the next. This results in a wave-like propagation of modulation as was addressed in context with the more generic fig. 4. Clearly respective mutual phasing between subsequent dipole members 15, which in fact accords with the relative angular position of the dipole members with respect to axis A, may be selected freely to result in a huge number of different modulation patterns to be exploited.

Up to now we have specifically addressed different embodiments for modulating the stationary magnetic field H_{S} as of fig. 1, 2 or 3.

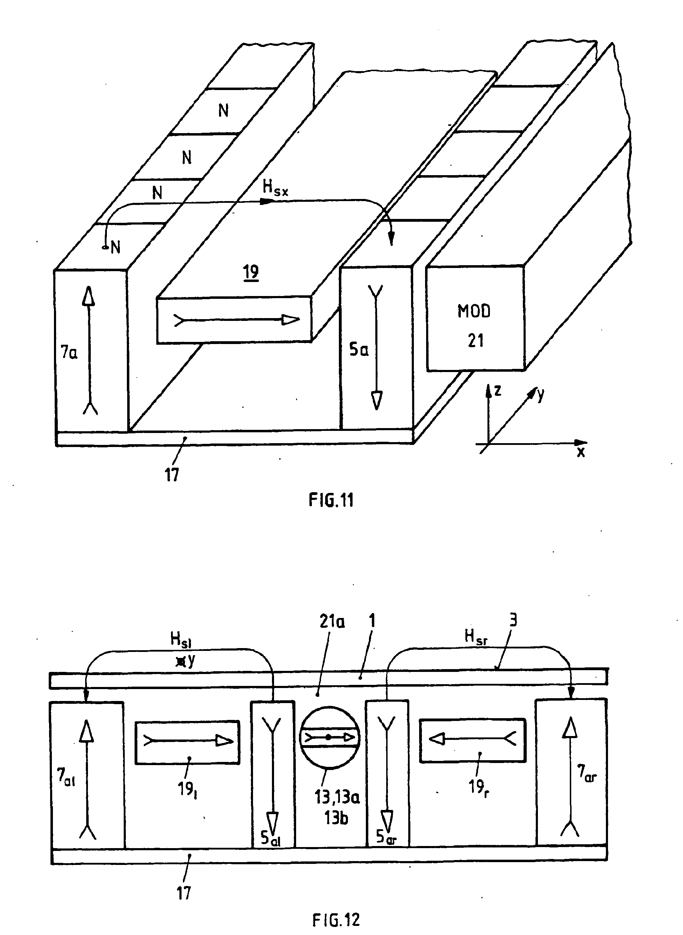

As was already addressed the principle according to the present invention has an advantage that the stationary magnetic field may be tailored with respect to shape and strength independently from the applied modulating magnetic field Hₘ. Fig. 11 shows in a representation in analogy to that of fig. 1 an embodiment of the present invention whereat, specifically, the stationary magnetic field H_{S} is tailored to have optimum magnetic field components H_{Sx} parallel to the sputtering surface. The stationary and elongated arrangement of magnetic poles 7a is polarized, as an example, in opposite direction compared with the arrangement 7 of fig. 1. This is purely an example, the addressed polarization could be made exactly as shown in fig. 1. There is again provided a first stationary and elongated arrangement of magnetic poles 5a which is spaced from the (not shown) target with the sputtering surface. The arrangements 5 and 7a are bridged by a ferromagnetic bridging member 17 which is provided in fact also in all other embodiments as of fig. 1 to 10 for generating the arcing stationary magnetic field H_{S}. Between the two stationary and elongated arrangements 5a and 7a there is situated a stationary and elongated dipole arrangement 19. The dipole direction is selected so that along the magnetic circuit with the arrangements 19, 5a, 17 and 7a no inversion of dipole polarity is established. Advantageously, the dipole arrangement 19 is spaced slightly further from the sputtering surface (not shown) than the magnetic pole forming surfaces of the respective arrangements 7a and 5a. Due to this arrangement there is achieved, as schematically shown, a substantially flattened pattern of magnetic field lines still forming respective arcs and a tunnel as was described in context with fig. 1. Thereby, the magnetic field components H_{Sx} parallel to the sputtering surface 3 as of fig. 1 are substantially homogenized considered in direction x and compared with the embodiment as of fig. 1. All the modulation embodiments as have been described with the help of the fig. 1 to 10 may be applied to realize the modulation unit MOD 21 shown in fig. 11.

All the embodiments as have been shown up to now do provide for one extended tunnel of stationary magnetic field H_{S} which is modulated according to the present invention. The approach according to the invention is nevertheless highly suited to be applied for magnetic field enhanced sputtering of the magnetron type, whereat the stationary magnetic field forms a closed tunnel loop upon the sputtering surface and especially the central area of the sputtering surface inside the addressed tunnel loop is less eroded, thereby leading to non-optimum target exploitation and to non-optimum homogeneity of distribution of sputter deposition along the surface of a substrate to be sputter-coated.

Fig. 12 shows an embodiment of a sputtering source according to the present invention and operating according to the method of the invention for magnetron-type magnetic field enhanced sputtering. The embodiment according to fig. 12 results in fact from doubling the embodiment shown in fig. 11 mirror-symmetrically. An outermost left stationary and elongated arrangement of magnetic pole 7ₐₗ cooperates with a more centrally arranged stationary and elongated arrangement of magnetic pole 5ₐₗ via stationary and elongated dipole arrangement 19₁ and ferromagnetic bridging part 17. Thereby, the left-hand leg Hₛ₁ of the stationary magnetic field H_{S} considered in y direction as of fig. 1 is generated. An outermost right stationary and elongated arrangement of magnetic pole 7ₐᵣ cooperates with stationary and elongated dipole arrangement 19ᵣ and a more centrally located stationary and elongated arrangement of magnetic pole 5ₐᵣ so as to generate the right-hand leg of the magnetic field tunnel according to Hₛᵣ. Between the pair of more centrally located stationary arrangements 5ₐₗ and 5ₐᵣ, generically spoken, there resides the modulation unit.

As perfectly clear to the skilled artisan such modulation unit may be realized as was specifically described with the help of the fig. 5 to 10. As shown in fig. 12 such modulation unit 21a is here realized by means of a drum 13, 13a or 13b as of one of the figs. 8 to 10.

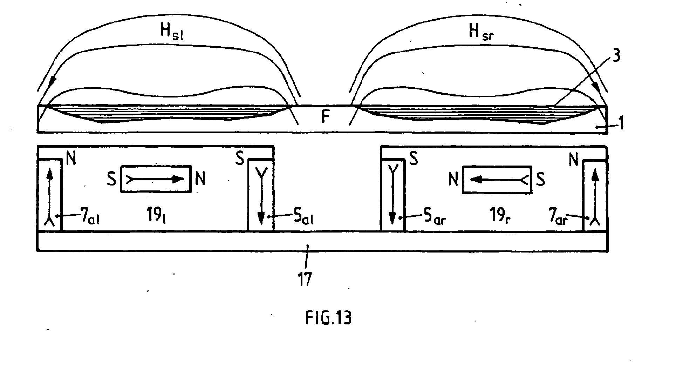

In fig. 13 there is shown the embodiment according to fig. 12 with no modulation of the stationary magnetic field H_{S1}, H_{Sr} and with the resulting erosion profile in the sputtering surface 3 and especially the area F of the sputtering surface which is not eroded.

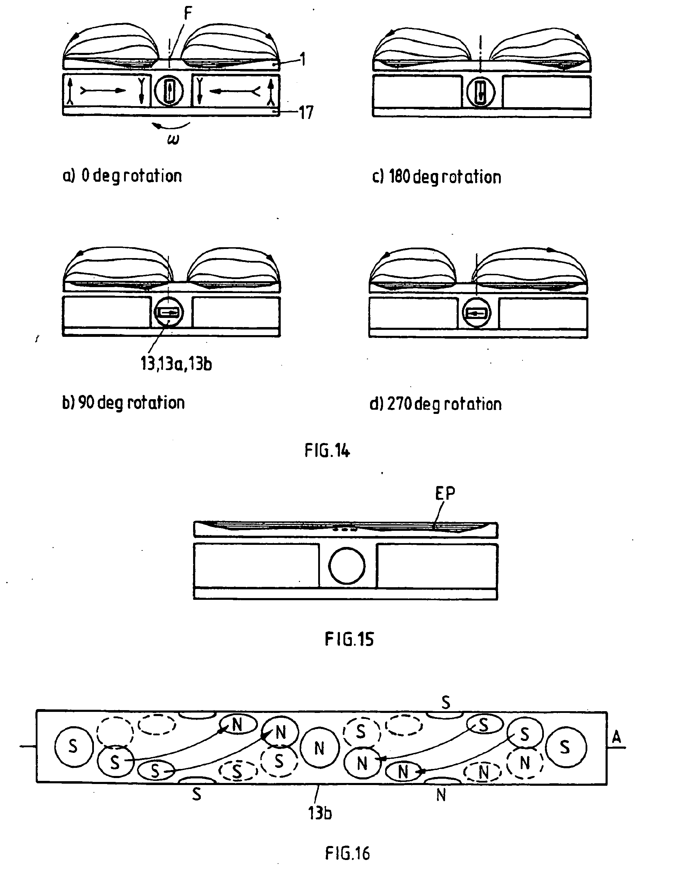

Fig. 14 (a) to (d) shows the embodiment of fig. 13 with the modulation unit realized by drum 13 or 13a or 13b of the fig. 8 to 10. Thereby, the specific figs. 14a to 14d show the time variation of the magnetic field resulting from superposition of the stationary magnetic field H_{S} as of fig. 13 with the modulating magnetic field Hₘ generated by the drivingly rotating drum 13, 13a, 13b. The drum with the magnetic dipole as indicated is thereby rotated by respective 90° in clock-wise direction from representation (a) to representation (d). There are further shown the erosion profiles in each of the drum positions in a shaded manner and the relative shift of the erosion-free area F upon the sputtering surface. For clearness reasons only few reference numbers are introduced in fig. 14. During sputtering and sputter-coating of one or more than one substrates the drum is drivingly rotated with a constant or variable angular speed ω.

Instead or additionally to the magnetic dipole members arranged along the revolving drum according to one of the embodiments according to fig. 8, 9 or 10 ferromagnetic material members may be provided at the drum. Whenever the drum is realized, as a good solution, according to the embodiment of fig. 10, in one embodiment the number of turns of the thread-like, helical pattern along the extent of the drum 13_{b} as of fig. 10 is an integer number. Thereby, torque forces between the magnets arranged along the drum 13_{b} and the stationary and elongated arrangements of magnetic pole 5ₐₗ and 5ₐᵣ are minimized.

As may be seen from fig. 12 to 14 in the respective embodiments there is realized magnetron-type, magnetic field enhanced sputtering, by respectively closing the electron trap formed by the tunnel-like pattern of magnetic field on both ends of the legs of the addressed tunnel. The rotational speed of the drum 13b may be adjusted according to the processing time for sputter-coating one more than one substrate simultaneously. The revolution speed ω becomes only critical if the processing time is below the revolving period. It is proposed to perform at least one or several revolutions by the drum 13b per process time in order to achieve a good uniformity of sputter-deposited coating. As may be seen from fig. 14a to 14d at any angle of rotation of drum 13b the magnetic field lines and the instant sputtering erosion profile on the sputtering surface 3 are different. If a revolving dipole is parallel to the dipoles of the stationary arrangements of magnetic poles, the left-hand and right-hand erosion profiles are symmetrical, but still different compared with sputtering without modulation as of fig. 13.

Any other angle of the revolving dipole results in a smaller or larger lateral shift of the magnetic field pattern just adjacent to the two stationary and elongated arrangements of magnetic poles and of the erosion profiles to the left and to the right. Any unsputtered area F whereupon sputter material is redeposited substantially disappears. A resulting overall erosion profile is shown in fig. 15.

In fig. 16 there is schematically shown in more details an embodiment of drum 13_{b} as of fig. 10. Tunnels of field lines are formed between respective magnetic poles at the drum. Such a drum 13b may be used to modulate plasma density of a plasma discharge. By rotating the drum 13b the pattern of magnetic poles moves linearly in the direction of the axis A.

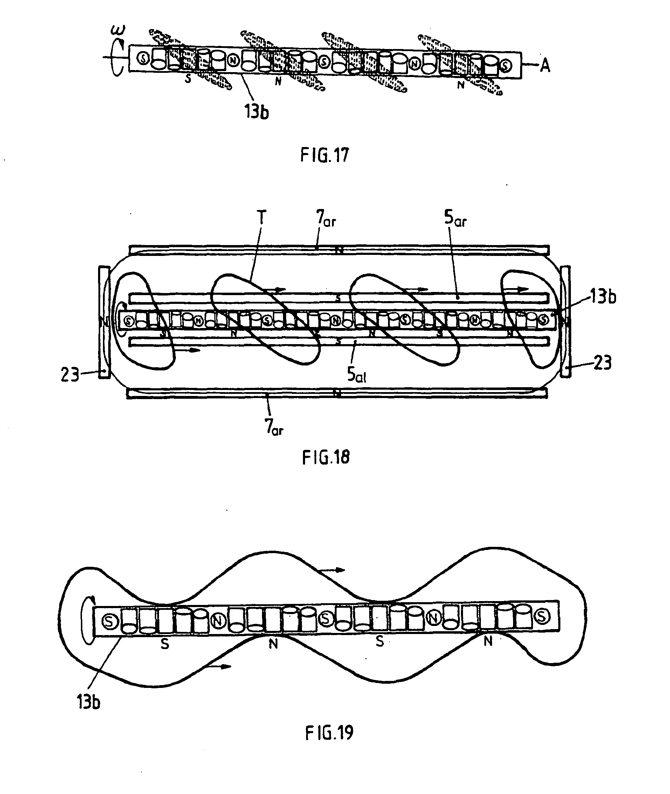

In fig. 17 there are shown the resulting areas of increased plasma density resulting from applying the drum as of fig. 16 beneath a plasma without additional magnetic fields.

In the embodiment of fig. 12 making use of drum 13_{b} with thread-like, helical pattern of magnetic poles and as shown in fig. 18, there is generated on one hand a magnetron electron trap by the stationary and elongated arrangements of magnetic pole and the terminating arrangements 23 of such poles. Additionally, by the interaction of the modulating magnetic field realized by drum 13_{b} with the adjacent stationary and elongated arrangements of magnetic poles 5ₐₗ and 5ₐᵣ according to fig. 12, central electron traps as shown at T in fig. 18 are generated which move in direction of the axis A of the revolving drum 13b.

Thereby and in the embodiment according to fig. 18 the stationary magnetic field Hₛ as of fig. 12 is relatively weak, so e.g. 10 Gauss to 200 Gauss with a modulating magnetic field generated by drum 13_{b} of 100 Gauss to 1000 Gauss.

Nevertheless the stationary magnetic field is thereby strong enough to form together with the modulating magnetic field the travelling closed tunnels of magnetic field resulting in the electron traps T as of fig. 18.

When the relative strength of the stationary magnetic field H_{S} relative to the modulating magnetic field Hₘ is changed so that the stationary magnetic field is relatively strong compared with the modulating magnetic field, the resulting pattern of electron traps as of fig. 18 switches to the pattern as shown in fig. 19. Thereby, the modulating magnetic field is selected in the range of 200 Gauss, whereas the stationary magnetic field in the range of about 250 Gauss. The stationary elongated arrangements of magnetic poles as shown in fig. 18 are not shown in fig. 19. There is formed a continuous snakelike moving electron trap as the drum 13_{b} rotates.

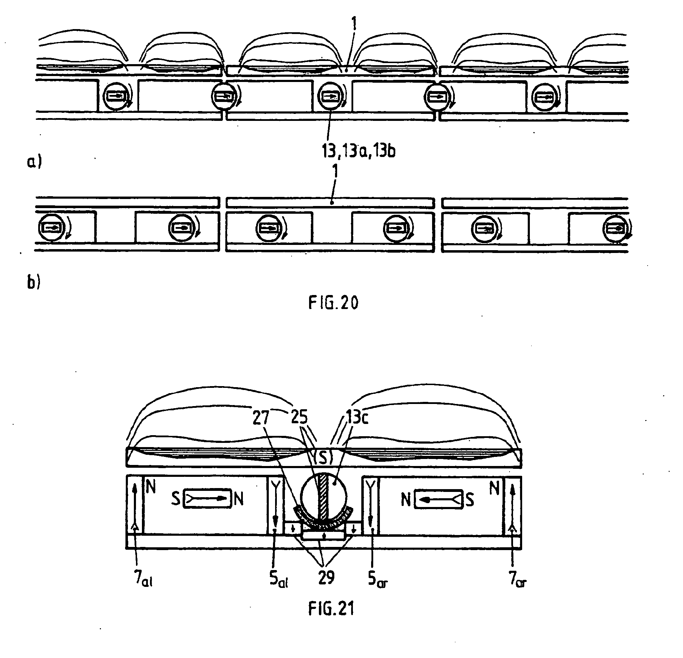

In fig. 20 there are shown, based on a representation according to that of fig. 14, two embodiments a) and b) with two rods per target 1. In the embodiment according to fig. 20(a) modulation by respective drums 13, 13a, 13b is performed between adjacent stationary and elongated arrangements of magnetic poles 7ₐₗ and 7ₐᵣ of neighbouring targets, thus in fact between these targets 1 and additionally and according to fig. 12 between the respective stationary and elongated arrangements of magnetic pole 5ₐₗ and 5ₐᵣ which latter are not shown in fig. 20. In the embodiment of fig. 20(b) magnetic field modulation is performed, with an eye on fig. 12, adjacent to the outer stationary and elongated arrangements of magnetic pole 7ₐₗ, 7ₐᵣ of each of the multiple targets 1.

In analogy to the modulation of the stationary magnetic field H_{S} by means of a modulating magnetic field which is realized by respective magnetic dipoles, it is possible to use ferromagnetic material to provide for the modulation. Such material does not generate its own magnetic field, but can modify existing magnetic fields in a similar way as is done by superimposing a modulating magnetic field.

According to the embodiment of fig. 21 the stationary magnetic field is generated as has been explained in context with fig. 12. Between the stationary and elongated arrangements 5ₐₗ and 5ₐᵣ of magnetic pole there is provided a drivingly rotatable drum 13_{c}. Along drum 13_{c} there are provided radially extending bars 25 of ferromagnetic material arranged equal to the dipoles at the respective drums of fig. 8 to 10. The drum 13_{c} revolves in a ferromagnetic pole shoe 27 by which the one-polarity poles of magnets 29 are collected. Thus, the ferromagnetic bars 25 present that magnetic poles (S) whenever such bars are adjacent to the pole shoe 27. In dependency of the angular position of the bars 25 modulation of the stationary magnetic fields at the left and at the right legs is realized very similar to the modulation which has been explained in context with fig. 14.

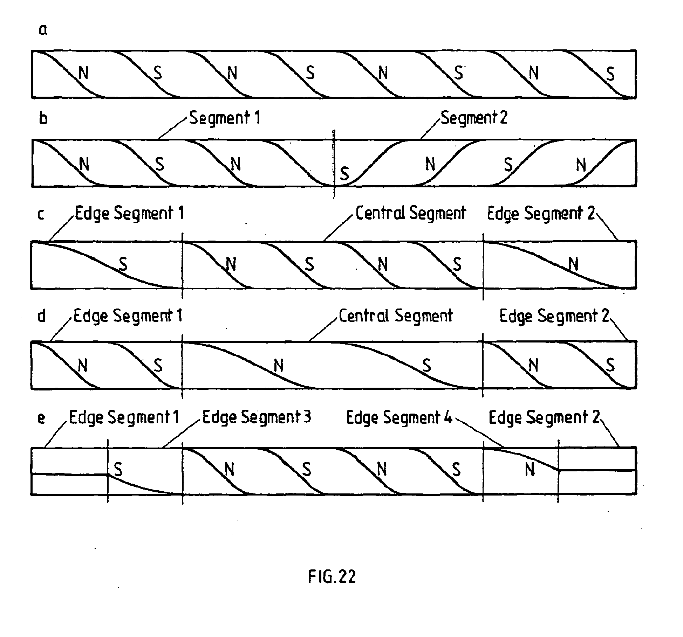

Whenever performing modulation of the stationary magnetic field H_{S} especially by means of a driven drum as has been addressed up to now, along such drum segments may be defined by which different modulations are performed. Thus, whenever making use of thread-like helical patterns, be it of magnetic poles and/or of ferromagnetic member surfaces along the surface of the drum, in different segments along the drum, different thread pitches may be applied, even different revolving speeds etc. In fig. 22 five examples are shown of a drum provided with a helical pattern of magnetic poles and whereat the helical patterns are different in predetermined segments along the extent of the drum.

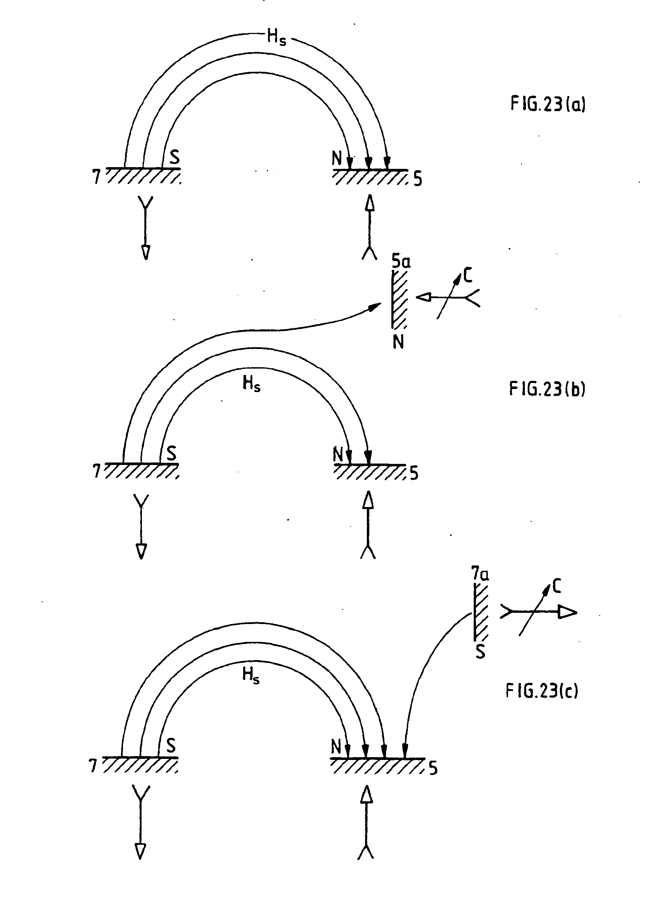

When looking back and having understood the present invention as generically explained e.g. with the help of the figures 1 to 9 it may be seen that this invention may also be considered from a different point of view and under a further aspect. This shall be explained with the help of fig. 23(a) to fig. 23(c). Fig. 23(a) shows in a schematic representation the first and second arrangements of magnetic poles 5, 7 and the stationary magnetic field H_{S} as was addressed to now. According to fig. 23(b) the stationary magnetic field H_{S} is controllably unbalanced as schematically shown by applying an auxiliary arrangement of magnetic poles 5ₐ adjacent to the stationary and elongated arrangement of magnetic poles 5. According to fig. 23(c) an auxiliary arrangement 7ₐ is provided adjacent to the stationary and elongated arrangement of magnetic poles 5. As a function of the respective magnetic polarities S, N which are presented by the auxiliary arrangements 5ₐ and 7ₐ to the stationary magnetic field H_{S} the addressed stationary magnetic field H_{S} as of fig. 23(a) is modulatingly unbalanced, thereby strengthening or weakening the tunnel-shaped and arcing stationary magnetic field H_{S} adjacent to the mono-polarity stationary and elongated arrangement of magnetic poles, according to fig. 23 arrangement 5.

As schematically shown by the control C of the auxiliary arrangement of magnetic poles, so as to alternatively present alternative magnetic poles to the addressed stationary and elongated arrangement 5 of magnetic poles, the stationary magnetic field H_{S} is modulated adjacent to the one stationary and elongated arrangement of magnetic poles 5 according to the present invention.

## Claims

1. A method of manufacturing at least one sputter coated substrate comprising:
magnetic field enhanced sputter coating said at least one substrate from a target arrangement comprising at least one sputter target (1)having a sputtering surface (3), thereby
• generating a time varying magnetic field (H(t)) on said surface (3)by a first(5) stationary and elongated arrangement of magnetic poles(N) and a second (7) stationary and elongated arrangement of magnetic poles(S), said first (5) and second (7) stationary and elongated arrangements being disposed mutually spaced and one along the other and at least one thereof beneath said sputtering surface (3), said first (5) and second (7) stationary and elongated arrangements commonly generating a magnetic field (H_{S}) having a pattern of magnetic field lines which is arcing above said surface (3)as considered in respective planes (Pl) perpendicular to said surface (3) and tunnel-like considered in a direction perpendicular to said planes;
• modulating said magnetic field at a position distant from said first (5) and said second (7) stationary and elongated arrangements of magnetic poles and along at least a predominant part of said stationary and elongated arrangements (5,7)
**characterised by**
• performing said modulating at a position closer to one (5) of said first(5) and second (7) stationary and elongated arrangements than to the other (7) of said first (5)and second (7) stationary and elongated arrangements, and
• said magnetic field (H_{S}) having a pattern of magnetic field lines which is arcing above said surface and which is stationary as a working point (H_{SX}) for said modulating.

2. The method of claim 1, comprising performing said modulation as a function of time and location along said at least one (5) stationary and elongated arrangement, thus in a wavelike manner along said one arrangement.

3. The method of one of claims 1 or 2, performing said modulating comprising moving a dynamic arrangement of one or alternate polarity magnetic poles at a position closer to one (5) of said first (5) and of said second (7) stationary and elongated arrangements of magnetic poles than to the other (7) of said first (5) and second (7) stationary and elongated arrangements, perpendicularly to and/or along said at least one (5) stationary and elongated arrangement of magnetic poles.

4. The method of one of claims 1 to 3, performing said modulating comprising moving a dynamic arrangement of ferromagnetic shunt members at a position closer to one (5) of said first (5) and of said second (7) stationary and elongated arrangements of magnetic poles than to the other (7) of said first (5)and second (7) stationary and elongated arrangements perpendicularly to and/or along said at least one stationary and elongated arrangement of magnetic poles, said members being mutually spaced in direction of said moving.

5. The method of one of claims 1 to 4, further comprising providing a third (5ₐᵣ) stationary and elongated arrangement of magnetic poles, said second (5ₐₗ) stationary arrangement being disposed in between said first (7ₐₗ) and said third (5ₐᵣ) stationary and elongated arrangements and beneath said sputtering surface (3), said modulating comprising said modulating at a position closer to said second (7) stationary and elongated arrangement of magnetic poles.

6. The method of one of claims 1 to 5, comprising performing said modulating by a modulating magnetic field which is stronger than said stationary magnetic field (H_{S}).

7. The method of one of claims 1 to 6, comprising performing said modulating by a modulating magnetic field which is weaker than said stationary magnetic field (H_{S}).

8. The method of one of claims 1 to 7, realizing said modulating comprising providing a drum (13a,13b,13c) rotatable about an axis at a position closer to one (5) of said first (5) and of said second (7) stationary and elongated arrangements of magnetic poles than to the other (7) of said first (5)and second (7) stationary and elongated arrangements along said at least one (5ₐₗ) stationary and elongated arrangement, said drum having at least one pattern of at least one of ferromagnetic members and of magnetic poles.

9. The method of claim 8, said pattern being a helical pattern around the surface of said drum.

10. The method of one of claims 1 to 9, thereby providing at least two targets disposed one beside the other, said one stationary and elongated arrangement of magnetic poles residing substantially between said at least two targets.

11. The method of one of claims 1 to 10, further comprising flattening said stationary magnetic field (H_{S}) by means of a stationary and elongated arrangement(19, 19₁,19ᵣ) of magnetic dipoles arranged along and between said first(5a)and second (7a) stationary and elongated arrangements of magnetic poles, with dipole axes substantially parallel and beneath said surface (3).

12. The method of one of claims 5 to 11, further comprising flattening said stationary magnetic field by means of stationary and elongated arrangements (19₁, 19ᵣ) of magnetic dipoles arranged along and between said first (5ₐₗ) and second (7ₐₗ) and between said third (7ₐᵣ) and second (5ₐₗ) stationary and elongated arrangements of magnetic poles, with dipole axes substantially parallel to and beneath said sputtering surface (3).

13. A sputtering source comprising:
• at least one sputter target (1) having a sputtering surface (3),
• a first stationary (5) and elongated arrangement of magnetic poles along said target (1),
• a second (7) stationary and elongated arrangement of magnetic poles, disposed mutually spaced and along said first (5) stationary and elongated arrangement of magnetic poles; at least one of said first and of said second stationary and elongated arrangements of magnetic poles being disposed beneath said sputtering surface, said first (5) and second (7) stationary and elongated arrangements commonly generating a magnetic field (H_{S}) having a pattern of magnetic field lines which is arcing upon said sputtering surface(3) as considered in respective planes (Pl) perpendicular to said sputtering surface(3) and tunnel-like considered in a direction perpendicular to said planes,
• a dynamic arrangement (9, 9a, 13, 13a, 13b, 13c) of at least one of spaced apart ferromagnetic members and of magnetic poles drivingly movable and at a position which is distant from said first (5) and second (7) stationary and elongated arrangements of magnetic poles,
**characterised by**
said dynamic arrangement being positioned closer to one of said first (5) and second (7) stationary and elongated arrangements than to the other (7) of said first(5) and second (7) stationary and elongated arrangements of magnetic poles
and wherein said magnetic field (H_{S}) having said pattern of magnetic field lines which is arcing upon said sputtering surface (3) is stationary.

14. The source of claim 13, said dynamic arrangement (9,9a,13,13a,13b,13c) of at least one of ferromagnetic members and of magnetic poles being drivingly movable perpendicularly to and/or along said one (5,5a,5ₐₗ) of said first and second stationary and elongated arrangements of magnetic poles.

15. The source of one of claims 13 or 14, comprising a third (5ₐᵣ,7ₐᵣ) stationary and elongated arrangement of magnetic poles, said second (5ₐₗ) stationary and elongated arrangement being disposed between and distant from said first(7ₐₗ) and said third (5ₐᵣ, 7ₐᵣ) stationary and elongated arrangements and beneath said sputtering surface (3), said one stationary and elongated arrangement of magnetic poles being said second (5ₐₗ) one.

16. The source of one of claims 13 to 15, wherein said stationary magnetic field (H_{S}) is stronger than a magnetic field generated with at least a part of magnetic poles of said dynamic arrangement(9,9a,13,13a,13b,13c), considered at a common locus along and adjacent said one stationary and elongated arrangement of magnetic poles.

17. The source of one of claims 13 to 16, wherein said stationary magnetic field (H_{S}) is weaker than a magnetic field generated with at least a part of magnetic poles of said dynamic arrangement(9,9a,13,13a,13b,13c), considered at a common locus along and adjacent said one stationary and elongated arrangement of magnetic poles.

18. The source of one of claims 13 to 17, said dynamic arrangement (9, 9a, 13, 13a, 13b, 13c) comprising a drum (13, 13a, 13b, 13c) drivingly rotatable about an axis and comprising a pattern of said at least one of ferromagnetic members and of magnetic poles.

19. The source of claim 18, said pattern being a helical pattern around the surface of said drum (13b).

20. The source of one of claims 13 to 19, comprising at least two targets disposed one beside the other, said one stationary and elongated arrangement of magnetic poles residing substantially between said at least two targets.

21. The source of one of claims 13 to 20, comprising a stationary and elongated arrangement (19) of magnetic dipoles along and between at least said first (5ₐₗ) and said second (7ₐₗ) stationary and elongated arrangements of magnetic poles, the axes of said dipoles being substantially parallel to said sputtering surface (3), and adjacent to and beneath said sputtering surface (3).

## Patentansprüche

1. Verfahren der Herstellung mindestens eines sputterbeschichteten Substrats, umfassend:
magnetfeldunterstütztes Sputterbeschichten besagten mindestens einen Substrats von einer Target-Anordnung, die mindestens ein Sputter-Target (1) mit einer Sputter-Oberfläche (3) umfasst, dabei,
• Erzeugen eines zeitvarianten Magnetfelds (H(t)) auf besagter Oberfläche (3) durch eine erste (5) stationäre und längsausgedehnte Anordnung von magnetischen Polen (N) und eine zweite (7) stationäre und längsausgedehnte Anordnung von magnetischen Polen (S), wobei besagte erste (5) und zweite (7) stationäre und längsausgedehnte Anordnungen zueinander beabstandet, eine entlang der anderen angeordnet sind und mindestens eine davon unterhalb besagter Sputter-Oberfläche (3), wobei besagte erste (5) und zweite (7) stationäre und längsausgedehnte Anordnungen gemeinsam ein Magnetfeld (H_{S}) erzeugen, mit einem Muster von Magnetfeldlinien, welches, betrachtet in entsprechenden Ebenen (Pl) senkrecht zu besagter Oberfläche (3), Bogen über besagter Oberfläche (3) bildet und welches, betrachtet in einer Richtung senkrecht zu besagten Ebenen, tunnelartig ist;
• Modulieren des besagten Magnetfeldes an einer Position, die entfernt von besagter ersten (5) und zweiten (7) stationären und längsausgedehnten Anordnungen von magnetischen Polen ist, und entlang zumindest eines überwiegenden Teils besagter stationären und längsausgedehnten Anordnungen (5,7)
**gekennzeichnet durch**
• Durchführen besagter Modulation an einer Position, die näher zu einer besagten ersten (5) und zweiten (7) stationären und längsausgedehnten Anordnungen ist als zu der anderen (7) besagter ersten (5) und zweiten (7) stationären und längsausgedehnten Anordnungen, und
• wobei besagtes Magnetfeld (H_{S}) ein Muster von Magnetfeldlinien aufweist, welches Bogen über besagter Oberfläche bildet und welches stationär ist als Arbeitspunkt (H_{SX}) für besagte Modulation.

2. Verfahren nach Anspruch 1, umfassend das Durchführen besagter Modulation als Funktion der Zeit und des Orts entlang besagter mindestens einen (5) stationären und längsausgedehnten Anordnung, somit in einer wellenförmigen Weise entlang besagter einen Anordnung.

3. Verfahren nach einem der Ansprüche 1 oder 2, wobei das Durchführen besagter Modulation Bewegen einer dynamischen Anordnung von magnetischen Polen der einen oder abwechselnder Polarität senkrecht zu und/oder entlang besagter mindestens einen (5) stationären und längsausgedehnte Anordnung von magnetischen Polen umfasst, an einer Position, die näher zu einer (5) der besagten ersten (5) und besagten zweiten (7) stationären und längsausgedehnten Anordnungen von magnetischen Polen ist als zu der anderen (7) der besagten ersten (5) und zweiten (7) stationären und längsausgedehnten Anordnungen.

4. Verfahren nach einem der Ansprüche 1 bis 3, wobei das Durchführen besagter Modulation Bewegen einer dynamischen Anordnung ferromagnetischer Shunt-Elemente senkrecht zu und/oder entlang besagter mindestens einen stationären und längsausgedehnten Anordnung von magnetischen Polen umfasst, an einer Position, die näher zu einer (5) der besagten ersten (5) und besagten zweiten (7) stationären und längsausgedehnten Anordnungen von magnetischen Polen ist als zu der anderen (7) der besagten ersten (5) und zweiten (7) stationären und längsausgedehnten Anordnungen, wobei besagte Elemente in Richtung besagter Bewegung voneinander beabstandet sind.

5. Verfahren nach einem der Ansprüche 1 bis 4, weiter umfassend Bereitstellen einer dritten (5ₐᵣ) stationären und längsausgedehnte Anordnung von magnetischen Polen, wobei besagte zweite (5ₐₗ) stationäre Anordnung zwischen besagter ersten (7ₐₗ) und besagter dritten (5ₐᵣ) stationären und längsausgedehnten Anordnung und unterhalb besagter Sputter-Oberfläche (3) angeordnet ist, wobei besagte Modulation besagte Modulation an einer Position umfasst, die näher zu besagter zweiten (7) stationären und längsausgedehnten Anordnung von magnetischen Polen ist.

6. Verfahren nach einem der Ansprüche 1 bis 5, umfassend Ausführen besagter Modulation durch ein modulierendes Magnetfeld, das stärker als besagtes stationäres Magnetfeld (H_{S}) ist.

7. Verfahren nach einem der Ansprüche 1 bis 6, umfassend Ausführen besagter Modulation durch ein modulierendes Magnetfeld, das schwächer als besagtes stationäres Magnetfeld (H_{S}) ist.

8. Verfahren nach einem der Ansprüche 1 bis 7, wobei Realisation besagter Modulation umfasst: Bereitstellen einer Trommel (13a, 13b, 13c), die um eine Achse rotierbar ist, an einer Position, welche näher zu einer (5) der besagten ersten (5) und zweiten (7) stationären und längsausgedehnten Anordnungen von magnetischen Polen ist als zu der anderen (7) besagter ersten (5) und zweiten (7) stationären und längsausgedehnten Anordnungen, entlang besagter mindestens einen (5ₐₗ) stationären und längsausgedehnten Anordnung, wobei besagte Trommel mindestens ein Muster von mindestens einem nämlich von ferromagnetischen Elementen und von magnetischen Polen aufweist.

9. Verfahren nach Anspruch 8, wobei besagtes Muster ein spiralförmiges Muster um die Oberfläche der besagten Trommel ist.

10. Verfahren nach einem der Ansprüche 1 bis 9, umfassend Bereitstellen mindestens zweier Targets, eines neben dem anderen, wobei besagte eine stationäre und längsausgedehnte Anordnung von magnetischen Polen im Wesentlichen zwischen besagten mindestens zwei Targets angeordnet ist.

11. Verfahren nach einem der Ansprüche 1 bis 10, weiter umfassend Abflachen besagten stationären Magnetfeldes (H_{S}) mittels einer stationären und längsausgedehnten Anordnung (19, 19₁, 19ᵣ) magnetischer Dipole, welche entlang und zwischen besagter ersten (5a) und zweiten (7a) stationären und längsausgedehnten Anordnung von magnetischen Polen angeordnet ist, mit Dipolaxen im wesentlichen parallel zu und unterhalb besagter Oberfläche (3).

12. Verfahren nach einem der Ansprüche 5 bis 11, weiter umfassend Abflachen besagten stationären Magnetfeldes mittels stationärer und längsausgedehnter Anordnungen (19₁, 19ᵣ) magnetischer Dipole, entlang und zwischen besagter ersten (5ₐₗ) und zweiten (7ₐₗ) und zwischen besagter dritten (7ₐᵣ) und zweiten (5ₐₗ) stationären und längsausgedehnten Anordnung von magnetischen Polen angeordnet, mit Dipolaxen im wesentlichen parallel zu und unterhalb besagter Sputter-Oberfläche (3).

13. Sputter-Quelle, umfassend:
• mindestens ein Sputter-Target (1) mit einer Sputter-Oberfläche (3),
• eine erste stationäre (5) und längsausgedehnte Anordnung magnetischer Pole entlang besagtem Target (1),
• eine zweiten (7) stationäre und längsausgedehnte Anordnung magnetischer Pole, beabstandet von und entlang besagter ersten (5) stationären und längsausgedehnten Anordnung magnetischer Pole; wobei mindestens eine der besagten ersten und besagten zweiten stationären und längsausgedehnten Anordnungen magnetischer Pole unterhalb besagter Sputter-Oberfläche angeordnet ist, und besagte erste (5) und zweite (7) stationäre und längsausgedehnte Anordnungen gemeinsam ein Magnetfeld (H_{S}) erzeugen mit einem Magnetfeldlinien-Muster, das, betrachtet in entsprechenden Ebenen (Pl) senkrecht zu besagter Oberfläche (3), Bogen über besagter Oberfläche (3) bildet und, betrachtet in einer Richtung senkrecht zu besagten Ebenen, tunnelartig ist,
• eine dynamische Anordnung (9, 9a, 13, 13a, 13b, 13c) von mindestens einem von: beabstandeter ferromagnetischer Elemente und von magnetischen Polen, die getrieben bewegbar sind an einer Position, die entfernt von besagter ersten (5) und zweiten (7) stationären und längsausgedehnten Anordnung von magnetischen Polen ist,
**dadurch gekennzeichnet dass**,
besagte dynamische Anordnung näher zu einer der besagten ersten (5) und zweiten (7) stationären und längsausgedehnten Anordnungen angeordnet ist als zu der anderen (7) besagter ersten (5) und zweiten (7) stationären und längsausgedehnten Anordnungen von magnetischen Polen und worin besagtes Magnetfeld (H_{S}), welches besagtes Muster von Magnetfeld-Linien bildet, das Bogen über besagter Sputter-Oberfläche (3) bildet, stationär ist.

14. Quelle nach Anspruch 13, wobei besagte dynamische Anordnung (9, 9a, 13, 13a, 13b, 13c) von mindestens einem von: ferromagnetischen Elementen und magnetischen Polen, senkrecht zu und/oder entlang besagter einen (5, 5a, 5ₐₗ) der ersten und zweiten stationären und längsausgedehnten Anordnungen von magnetischen Polen getrieben bewegbar ist.

15. Quelle nach einem der Ansprüche 13 oder 14, umfassend eine dritte (5ₐᵣ, 7ₐᵣ) stationäre und längsausgedehnte Anordnung von magnetischen Polen, wobei besagte zweite (5ₐₗ) stationäre und längsausgedehnte Anordnung zwischen und entfernt von besagter ersten (7ₐₗ) und besagter dritten (5ₐᵣ) stationären und längsausgedehnten Anordnung und unterhalb besagter Sputter-Oberfläche (3) angeordnet ist, und besagte eine stationäre und längsausgedehnte Anordnung von magnetischen Polen die besagte zweite (5ₐₗ) ist.

16. Quelle nach einem der Ansprüche 13 bis 15, wobei besagtes stationäres Magnetfeld (H_{S}), betrachtet an einem gemeinsamen Ort entlang und benachbart zu besagter einen stationären und längsausgedehnten Anordnung von magnetischen Polen, stärker ist als ein Magnetfeld, das mit mindestens einem Teil der magnetischen Pole besagter dynamischen Anordnung (9, 9a, 13, 13a, 13b, 13c) erzeugt ist.

17. Quelle nach einem der Ansprüche 13 bis 16, worin besagtes stationäre Magnetfeld (H_{S}), betrachtet an einem gemeinsamen Ort entlang und benachbart zu besagter einen stationären und längsausgedehnten Anordnung von magnetischen Polen, schwächer ist als ein Magnetfeld, das mit mindestens einem Teil der magnetischen Pole besagter dynamischen Anordnung (9, 9a, 13, 13a, 13b, 13c) erzeugt ist.

18. Quelle nach einem der Ansprüche 13 bis 17, wobei besagte dynamische Anordnung (9, 9a, 13, 13a, 13b, 13c) eine Trommel (13, 13a, 13b, 13c) umfasst, welche getrieben um eine Achse drehbar ist und ein Muster von mindestens einem besagter: ferromagnetischer Elemente und magnetischen Pole, umfasst.

19. Quelle nach Anspruch 18, wobei besagtes Muster ein spiralförmiges Muster um die Oberfläche besagter Trommel (13b) ist.

20. Quelle nach einem der Ansprüche 13 bis 19, umfassend mindestens zwei Targets, eines neben dem anderen angeordnet, wobei besagte eine stationäre und längsausgedehnte Anordnung von magnetischen Polen im wesentlichen zwischen besagten mindestens zwei Targets angeordnet ist.

21. Quelle nach einem der Ansprüche 13 bis 20, mit einer stationären und längsausgedehnten Anordnung (19) magnetischer Dipole, entlang und zwischen mindestens besagter ersten (5ₐₗ) und besagter zweiten (7ₐᵢ) stationären und längsausgedehnten Anordnung von magnetischen Polen, wobei die Achsen besagter Dipole im wesentlichen parallel zu, benachbart und unterhalb besagter Sputter-Oberfläche (3) angeordnet sind.

## Revendications

1. Un procédé de fabrication d'au moins un substrat revêtu par pulvérisation cathodique, comprenant:
revêtement par pulvérisation cathodique intensifié par champ magnétique, dudit au moins un substrat à partir d'un arrangement de cible, comprenant au moins une cible de pulvérisation cathodique (1) ayant une surface de pulvérisation cathodique (3),
• générer un champ magnétique variant en temps (H(t)) sur ladite surface (3) par un premier (5) arrangement de pôles magnétiques (N) stationnaire allongé et un second (7) arrangement de pôles magnétiques (S) stationnaire allongé, lesdits premier (5) et second (7) arrangements stationnaires et allongés étant disposés de façon mutuellement distante l'un le long de l'autre, et au moins un au-dessous de ladite surface de pulvérisation cathodique (3), lesdits premiers (5) et seconds (7) arrangements stationnaires allongés générant ensemble un champ magnétique (H_{S}) ayant un motif de lignes de champ magnétique qui arque au-dessus de ladite surface (3, considéré dans des plans respectives (P1) perpendiculaires à ladite surface (3) et sous forme de tunnel, considéré en direction perpendiculaire audit plans;
• moduler ledit champ magnétique à une position distante dudit premier (5) et dudit second (7) arrangement de pôles magnétiques stationnaires et allongés et le long au moins une partie prédominante desdits arrangements (5,7) stationnaires allongés,
**caractérisé par**
• performer ladite modulation à une position plus proche d'un (5) desdits premiers (5) et seconds (7) arrangements stationnaires et allongés qu' à l'autre (7) desdits premiers (5) et seconds (7) arrangements stationnaires et allongés, et
• ledit champ magnétique (H_{S}) ayant un motif de lignes de champ magnétique qui arque au-dessus de ladite surface et qui est stationnaire comme point de travail (H_{SX}) pour ladite modulation.

2. Procédé selon la revendication 1, comprenant performer ladite modulation en fonction de temps et de lieu le long dudit au moins un (5) arrangement stationnaire et allongé, donc sous forme d'onde le long dudit un arrangement.

3. Procédé selon une des revendications 1 ou 2, perforer ladite modulation comprenant mouvoir un arrangement dynamique d'un ou de pôles magnétiques alternants à une position plus proche à un (5) dudit premier (5) et dudit second (7) arrangements stationnaires et allongés de pôles magnétiques qu' à l'autre (7) dudit premier (5) et second (7) arrangements stationnaires et allongés, de façon perpendiculaire à et/ou le long dudit au moins un (5) arrangement stationnaire et allongé de pôles magnétiques.

4. Procédé selon une des revendications 1 à 3, performer ladite modulation comprenant mouvoir un arrangement dynamique de membres ferromagnétiques shunt à une position plus proche à un (5) dudit premier (5) et dudit second (7) arrangements stationnaires allongés de pôles magnétiques qu' à l'autre (7) dudit premier (5) et dudit second (7) arrangement stationnaire et allongé de façon perpendiculaire et/ou le long dudit au moins un arrangement stationnaire allongé de pôles magnétiques, lesdits membres étant arrangés à distance mutuelle en direction dudit mouvoir.

5. Procédé selon une des revendications 1 à 4, de plus comprenant prévoir un troisième (5ₐᵣ) arrangement stationnaire allongé de pôles magnétiques, ledit second arrangement (5ₐₗ) stationnaire étant disposé entre ledit premier (7ₐₗ) et ledit troisième (5ₐᵣ) des arrangements stationnaires allongés et en dessous de ladite surface de pulvérisation cathodique (3), comprenant ladite modulation à une position plus proche audit second (7) arrangement stationnaire allongé de pôles magnétiques.

6. Procédé selon une des revendications 1 à 5, comprenant performer ladite modulation par un champ magnétique modulant qui est plus fort que ledit champ magnétique (Hₛ) stationnaire.

7. Le procédé selon une des revendications 1 à 6, comprenant performer ladite modulation par un champ magnétique modulant qui est plus faible que ledit champ magnétique stationnaire (Hₛ).

8. Procédé selon une des revendications 1 à 7, implémenter ladite modulation comprenant prévoir un tambour (13a, 13b, 13c) capable d'effectuer une rotation autour d'un axe (5) à une position plus proche d'un dudit premier (5) et dudit second (7) arrangements stationnaires allongés de pôles magnétiques que de l'autre (7) dudit premier (5) et second (7) arrangement stationnaire allongé et le long dudit au moins un (5ₐ₁) des arrangements stationnaires allongés, ledit tambour ayant une configuration d'au moins un membre ferromagnétique et/ou de pôles magnétiques.

9. Procédé selon la revendication 8, ladite configuration étant une configuration hélicoïdale autour de la surface dudit tambour.

10. Procédé selon une des revendications 1 à 9, comprenant prévoire au moins deux cibles disposées une à côté de l'autre, ledit un arrangement stationnaire allongé de pôles magnétiques résidant substantiellement entre lesdites au moins deux cibles.

11. Procédé selon une des revendications 1 à 10, de plus comprenant aplatir ledit champ magnétique stationnaire (Hₛ) par un arrangement stationnaire allongé (19, 19₁, 19ᵣ) de pôles magnétiques le long du et entre lesdits premier (5a) et deuxième (7a) arrangements stationnaires allongés de pôles magnétiques, avec des axes de dipôle substantiellement parallèles et en dessous de ladite surface (3).

12. Procédé selon une des revendications 5 à 11, de plus comprenant aplatir ledit champ magnétique stationnaire par des arrangements stationnaires allongés (19, 19₁, 19ᵣ) de pôles magnétiques le long des et entre lesdits premier (5ₐ₁) et second (7ₐ₁) arrangements stationnaires allongés, avec des axes de dipôle substantiellement parallèles à et en dessous la dite surface de pulvérisation cathodique (3).

13. Source de pulvérisation cathodique comprenant:
• au moins une cible (1) de pulvérisation ayant une surface de pulvérisation cathodique (3),
• un premier arrangement stationnaire (5) allongé de pôles magnétiques le long de ladite cible (1),
• un second (7) arrangement stationnaire allongé de pôles magnétiques, disposé à distance mutuellement le long dudit premier (5) arrangement stationnaire allongé de pôles magnétiques; au moins un dudit premier et dudit second arrangements stationnaires allongés des pôles magnétiques étant disposés en dessous de ladite surface de pulvérisation cathodique, lesdits premier (5) et second (7) arrangements stationnaires allongés générant ensemble un champ magnétique (Hₛ) ayant un motif de lignes de champ magnétique qui arque en dessus de ladite surface de pulvérisation cathodique (3), considéré dans des plans respectives (P1) perpendiculaires à ladite surface de pulvérisation cathodique (3) et sous forme de tunnel, considéré en direction perpendiculaire audit plans,
• un arrangement dynamique (9, 9a, 13, 13a, 13b, 13c) d'au moins un membre ferromagnétique arrangé à distance de façon séparé et/ou de pôles magnétiques entraînés de façon mouvable et à une position qui est distante desdits premier (5) et second (7) arrangements stationnaires allongés de pôles magnétiques,
**caractérisé par**
ledit arrangement dynamique étant positionné plus proche d' un desdits premier (5) et second (7) arrangements stationnaires allongés qu' à l'autre (7) desdits premier et second (7) arrangements stationnaires allongés de pôles magnétiques
et ledit champ magnétique (Hₛ) ayant ledit motif de lignes de champ magnétique arqué en dessus de ladite surface de pulvérisation cathodique (3) étant stationnaire.

14. Source selon la revendication 13, ledit arrangement dynamique (9, 9a, 13, 13a, 13b, 13c) d'au moins un membre ferromagnétique et/ou de pôles magnétiques étant entraîné de façon mouvable de façon perpendiculaire et/ou le long dudit un (5, 5a, 5ₐ₁) desdits premier et second arrangements stationnaires allongés de pôles magnétiques.

15. Source selon une des revendications 13 ou 14, comprenant un troisième (5ₐᵣ, 7ₐᵣ) arrangement stationnaire allongé de pôles magnétiques, ledit second (5ₐ₁) arrangement stationnaire allongé étant disposé entre et à distance dudit premier (7ₐ₁) et dudit troisième (5ₐᵣ, 7ₐᵣ) arrangements stationnaires allongés et en dessous de ladite surface de pulvérisation cathodique (3), ledit arrangement stationnaire allongé de pôles magnétiques étant ledit second (5ₐ₁) arrangement.

16. Source selon une des revendications 13 à 15, ledit champ magnétique (Hₛ) stationnaire étant plus fort qu'un champ magnétique généré par au moins une partie de pôles magnétiques dudit arrangement dynamique (9, 9a, 13, 13a, 13b, 13c) considéré à un lieu commun le long et adjacent dudit un arrangement stationnaire allongé de pôles magnétiques.

17. Source selon une des revendications 13 à 16, ledit champ magnétique (Hₛ) stationnaire étant plus faible qu'un champ magnétique généré par au moins une partie de pôles magnétiques dudit arrangement dynamique (9, 9a, 13, 13a, 13b, 13c), considéré à un lieu commun le long et adjacent dudit un arrangement stationnaire allongé de pôles magnétiques.

18. Source selon une des revendications 13 à 17, ledit arrangement dynamique (9, 9a, 13, 13a, 13b, 13c) comprenant un tambour (13, 13a, 13b, 13c) entraîné de façon mouvable autour d'un axe et comprenant une configuration dudit au moins un membre ferromagnétique et/ou de pôles magnétiques.

19. Source selon la revendication 18, ladite configuration étant une configuration hélicoïdale autour de la surface dudit tambour (13b).

20. Source selon une des revendications 13 à 19, comprenant au moins deux cibles disposées une à côté de l'autre, ledit un arrangement stationnaire allongé de pôles magnétiques résidant substantiellement entre lesdites deux cibles.

21. Source selon une des revendications 13 à 20, comprenant un arrangement stationnaire et allongé (19) de dipôles magnétiques entre et le long ledit premier (5ₐ₁) et ledit second (7ₐᵢ) arrangement stationnaire allongé de pôles magnétiques, les axes desdits dipôles étant substantiellement parallèles à ladite surface de pulvérisation cathodique (30), et adjacent à et en dessous de ladite surface de pulvérisation cathodique (3).
